Europäisches Patentamt

European Patent Office

Office européen des brevets

(11) Publication number: **0 484 760 A2**

# EUROPEAN PATENT APPLICATION

(21) Application number: **91118196.4**

(22) Date of filing: **24.10.91**

(51) Int. Cl.5: **G11C 11/406**, G11C 11/407

(30) Priority: **08.11.90 JP 303279/90**
**27.11.90 JP 324311/90**

(43) Date of publication of application:
**13.05.92 Bulletin 92/20**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Iizuka, Emiko, c/o Intellectual**
**Property Division**
**Kabushiki Kaisha Toshiba, 1-1 Shibaura**
**1-chome**
**Minato-ku, Tokyo 105(JP)**
Inventor: **Nakajima, Shuzo, c/o Intellectual**
**Property Div.**
**Kabushiki Kaisha Toshiba, 1-1 Shibaura**
**1-chome**
**Minato-ku, Tokyo 105(JP)**

(74) Representative: **Henkel, Feiler, Hänzel &**
**Partner**
**Möhlstrasse 37**
**W-8000 München 80(DE)**

(54) Memory refresh control system upon connection of extension unit.

(57) In a portable computer having an extension bus connector connected to a system bus, and a memory connected to an internal bus, and requiring a refresh operation, whether or not an extension unit is connected to the extension bus connector is checked. When the extension unit is connected to the extension bus connector, a refresh signal is output onto the system bus. When the extension unit is not connected to the extension bus connector, the refresh signal is output onto the internal bus. Only when the extension unit is connected to the extension bus connector, the refresh signal is output onto the system bus. When the refresh cycle of a memory incorporated in the portable computer is longer than that of a memory connected to the extension unit, the presence/absence of connection of the extension unit is detected, and a refresh mode is set to be a normal refresh mode.

START

S21 — SETTING OF PROCESSING SPEED OF BACKUP MEMORY — NORMAL REFRESH

HIGH-SPEED REFRESH

S22 — IS EXPANSION UNIT CONNECTED ? — PRESENCE OF EXTENSION UNIT

ABSENCE OF EXTENSION UNIT

S23 — SET IN REFRESH CONTROL REGISTER HIGH-SPEED REFRESH MODE

S24 — SET IN REFRESH CONTROL REGISTER NORMAL MEMORY REFRESH

END

F I G. 5

The present invention relates to a portable computer having an extension unit interface function of extending a system function by connecting an extension unit to an extension bus connector so as to bus-connect an extension device mounted on the extension unit to a portable computer main body.

In recent years, various lap-top type portable computers, which are readily carried, and can be driven by batteries, have been developed. In a portable computer of this type, in order to extend its function, extension devices can be extended as needed in addition to various standard devices incorporated in the portable computer main body.

As the extension devices, an extension memory board, a communication board, and an interface board for achieving various interfaces between the portable computer main body and an external apparatus are connected.

The extension device is normally connected to a system bus of the portable computer via an extension bus connector, and is controlled using a refresh signal on the system bus. The refresh signal on the system bus is originally used for refresh-controlling, e.g., an internal RAM connected to the system bus, and can also be used for controlling the extension device as follows.

For example, as for the extension memory board for the extension device, refresh control is made using the refresh signal on the system bus. As for the communication board for the extension device, the refresh signal on the system bus is used for executing, e.g., time-out processing. The extension device uses the refresh signal on the system bus to, e.g., establish synchronization with the main body side.

Therefore, a CPU of the portable computer main body outputs the refresh signal onto the system bus to guarantee the operation of the extension device.

However, to output the refresh signal onto the system bus results in an increase in load on the CPU, and a limit in the use of the system bus by devices connected to the system bus and incorporated in the main body. In particular, in a relatively high-function portable computer in which many devices are connected to its system bus, the operations of these devices are restricted by occupation of the system bus by the refresh signal, thus impairing operation performance of the overall system.

It is an object of the present invention to provide a portable computer having a mechanism capable of guaranteeing an operation of an extension device without impairing operation performance of the overall system.

According to the first aspect of the present invention, a portable computer comprises: a system bus; an extension bus connector connected to the system bus; an internal bus; a memory connected to the internal bus, and requiring a refresh signal; means for determining whether or not an extension unit is connected to the extension bus connector, and outputting a discrimination signal, a memory being able to be connected to the extension unit; means, connected to the system bus and the internal bus, for generating the refresh signal to be supplied to the memory; and means, responsive to the determination signal, for, when the extension unit is connected to the extension bus connector, outputting the refresh signal onto the system bus, and for, when the extension unit is not connected to the extension bus connector, outputting the refresh signal onto the internal bus.

According to the second aspect of the present invention, a portable computer comprises: an extension bus connector for connecting an extension unit; a first memory incorporated in the portable computer, and comprising one of a memory operated in a first refresh mode, and a memory operated in a second refresh mode having a refresh cycle shorter than that of the first refresh mode; means for discriminating whether or not the extension unit is connected to the extension bus connector, a second memory which is operated in the second refresh mode being able to be connected to the extension unit; means for setting the first refresh mode; and means for, when the refresh mode of the first memory is set in the first refresh mode, determining that the extension unit is connected to the extension bus connector, operating the first and second memories in the second refresh mode, and for, when the extension unit is not connected, operating the first memory in the first refresh mode.

According to the present invention, when the extension unit is not connected, the refresh signal is output onto the internal bus, and only when the extension unit is connected to the extension bus connector, the refresh signal is output onto the system bus. Therefore, the operation of the extension device can be guaranteed without impairing operation performance of the overall system.

Furthermore, according to the present invention, a high-speed refresh mode is set with reference to a refresh mode set in setup processing. In addition, when the extension unit is not connected, a high-speed memory refresh mode is set. When the extension unit is connected, a normal refresh mode is set. As a result, when the extension unit is not connected, the characteristics of the memory connected to the main body, and capable of performing a high-speed memory refresh operation can be utilized. On the other hand, when the extension unit is connected, the operation of the memory of the extension unit, which memory can perform a normal memory refresh operation, can be guaranteed.

This invention can be more fully understood from the following detailed description when taken in conjunction with the accompanying drawings, in which:

Fig. 1 is a block diagram showing a portable computer according to an embodiment of the present invention;

Fig. 2 is a detailed block diagram of a refresh mode controller shown in Fig. 1;

Fig. 3 is a detailed block diagram of a refresh signal generator shown in Fig. 2;

Fig. 4 is a flow chart showing power-on initialization processing in the embodiment of the present invention; and

Fig. 5 is a flow chart showing processing for controlling high-speed and normal refresh modes according to another embodiment of the present invention.

An embodiment of the present invention will be described below with reference to the accompanying drawings.

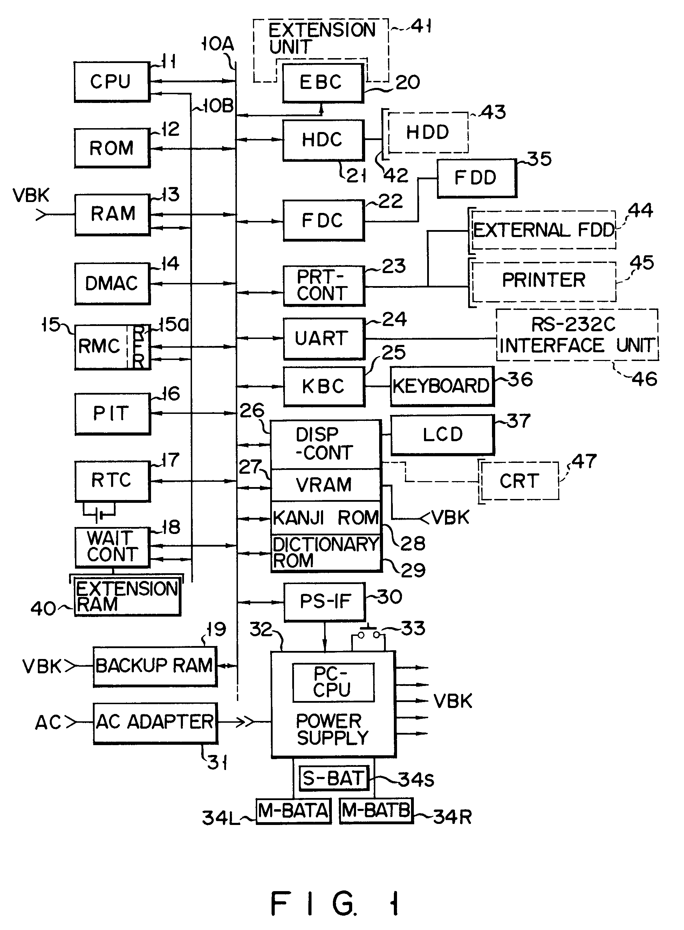

Fig. 1 is a block diagram showing an arrangement of a portable computer according to an embodiment of the present invention.

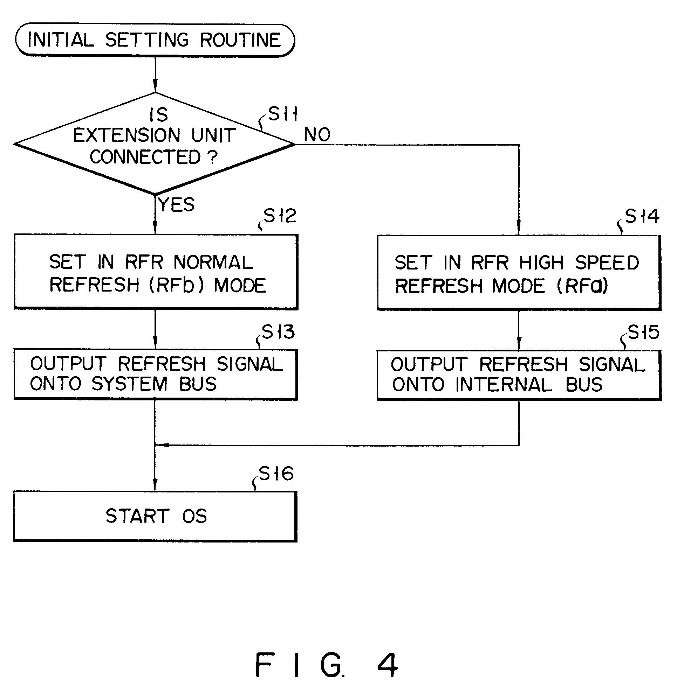

In Fig. 1, reference numeral 10A denotes a system bus; and 10B, an internal bus. Reference numerals 11 through 30 are components to be connected to the system bus 10A. Of these components, reference numeral 11 denotes a CPU (main CPU) for controlling the overall system. The CPU 11 accesses a BIOS-ROM 12 upon power-on, and executes initialization processing including an initial setting routine for determining a bus (the system bus 10A or the internal bus 10B) to which a memory refresh signal is to be output, as shown in Fig. 4.

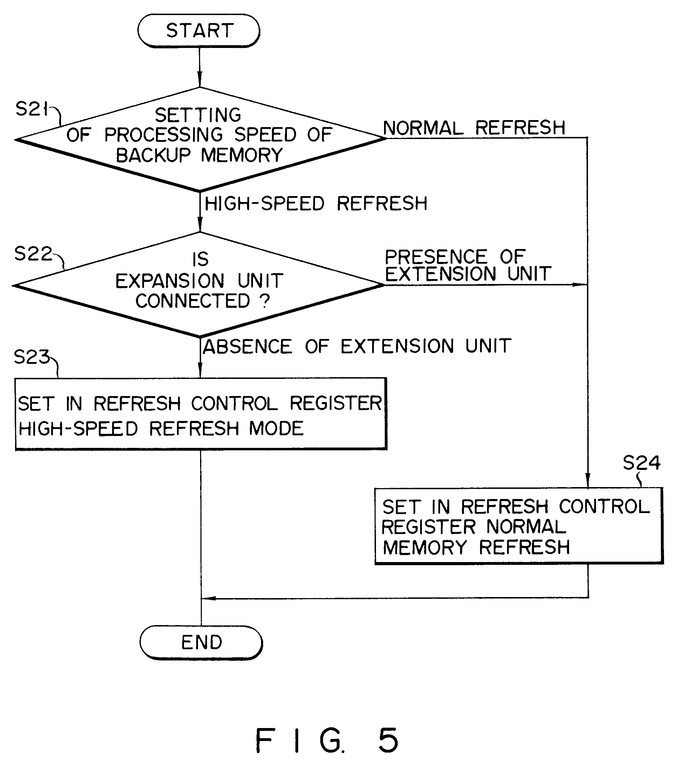

Reference numeral 12 denotes the BIOS-RAM for storing, e.g., a permanent program. The initialization processing program includes processing routines for executing processing operations shown in Figs. 4 and 5.

Reference numeral 13 denotes a RAM constituting a main memory for storing a program, data, and the like to be processed, and comprising a plurality of dynamic RAMs. The RAM 13 is connected not only to the system bus 10A but also to the internal bus 10B. Reference numeral 14 denotes a DMA controller (DMAC; Direct Memory Access Controller) for performing direct memory access control.

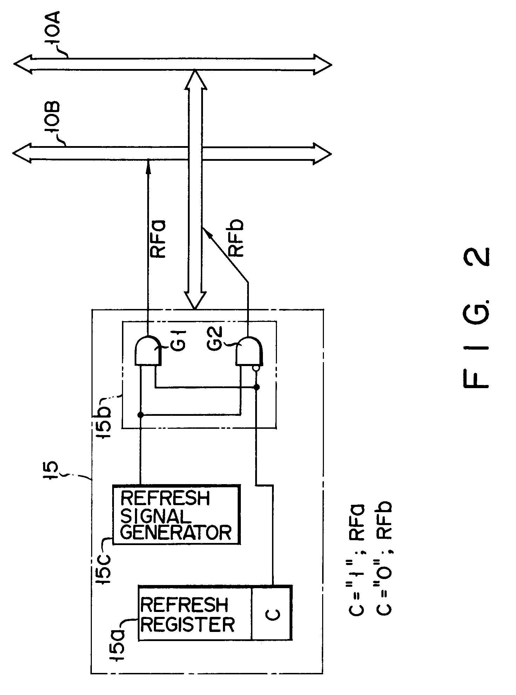

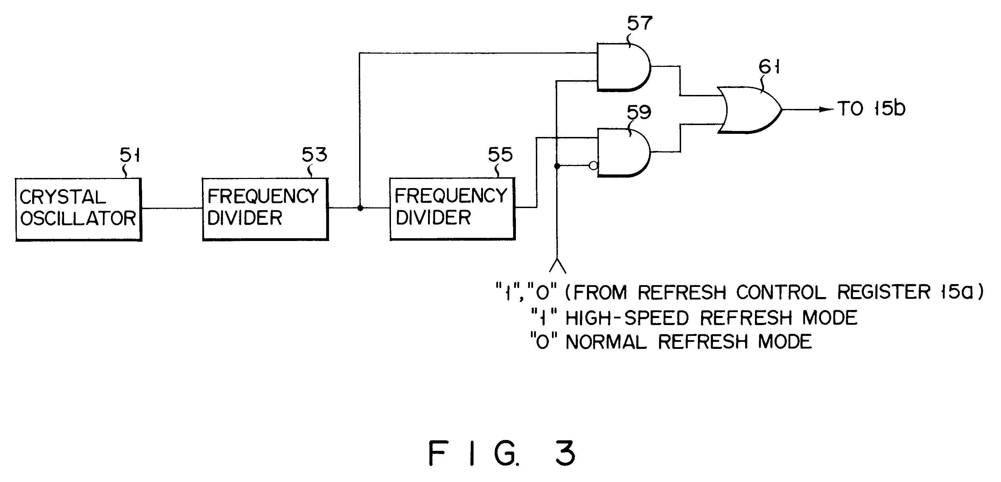

Reference numeral 15 denotes a refresh mode controller (RMC) for controlling generation and switching of a refresh signal used in a memory refresh operation. The refresh mode controller 15 selectively outputs a memory refresh signal onto the system bus 10A or the internal bus 10B in accordance with a content of a control bit (C) of a refresh control register (RFR) 15a. The arrangement of the refresh mode controller 15 will be described in detail below with reference to Figs. 2 and 3.

Reference numeral 16 denotes a programmable interval timer (PIT), which includes a programmable interrupt controller (PIC). Reference numeral 17 denotes a real-time clock (RTC) which has a self-operation battery, and stores data such as date data, time data, system control data, and the like which must always be preserved.

Reference numeral 18 denotes a wait controller (WAIT-CONT) for switching a wait time for determining a read/write cycle time in accordance with the type of extension RAM 40 (in this embodiment, assume that an old type low-speed memory card comprises a 1- or 2-MB RAM, and a new type high-speed memory card comprises a 4- or 8-MB RAM) to be mounted on a special-purpose card slot of the main body, and controlling access of the mounted extension RAM (memory card) 40. The wait controller 18 is connected not only to the system bus 10A but also to the internal bus 10B in the same manner as the RAM 13.

Reference numeral 19 denotes a backup RAM serving as a data storage area for realizing a resume function. The backup RAM 19 is supplied with a backup power supply (VBK).

Reference numeral 20 denotes an extension bus connector (EBC), to which various extension optional devices such as an extension memory board, a communication board, and the like, mounted on an extension unit 41 are connected.

Reference numeral 21 denotes a hard disk controller (HDC) for interface-connecting a hard disk pack to be stored in the main body when the portable computer main body is upgraded to a hard-disk (HDD) mount type (which mounts one HDD and one FDD). When the portable computer main body is upgraded, the hard disk controller 21 is interface-connected to a hard disk pack 43 via an internal connector 42 arranged in a hard disk storage portion in the main body.

Reference numeral 22 denotes a floppy disk controller (FDC), which can control one floppy disk drive (FDD) 35.

Reference numeral 23 denotes a printer controller (PRT-CONT) to which, e.g., a 5" external floppy disk drive 44, a printer 45, or the like is selectively connected via a connector. Reference numeral 24 denotes an input/output interface (UART; Universal Asynchronous Receiver/Transmitter), to which an RS-232C interface device 46, or the like is connected, as needed. Reference numeral 25 denotes a keyboard controller (KBC) for controlling inputs from a keyboard 36 integrally arranged on the apparatus main body which packages a CPU board. Reference numeral 26 denotes a display controller (DISP-CONT). In this embodiment, the display controller 26 drives only an LCD 37 with a backlight (or side light), which is packaged in a display unit housing pivotally arranged on the apparatus main body. In addition, the display controller 26 can also control a display drive operation of a CRT display unit 47 as an external display. Reference numeral 27 denotes a video RAM (VRAM) supplied with the backup power supply (VBK); 28, a kanji ROM for obtaining a kanji character pattern in accordance with a kanji character code; and 29, a dictionary ROM for realizing a kana/kanji conversion dictionary, and the like. Reference numeral 30 denotes a power supply control interface (PS-IF) for connecting a power supply circuit (intelligent power supply) 32 to the CPU 11 via the system bus 10A. The power supply control interface 30 has a serial-parallel conversion function for performing a data transfer operation with a power control CPU (PC-CPU) of the power supply circuit 32 using a serial interface. Reference numeral 31 denotes a power supply adapter (to be referred to as an AC adapter hereinafter) for rectifying and smoothing a commercial AC power supply to obtain a DC operation power supply of a predetermined potential. The AC adapter is plug-in-connected to the portable computer main body. Reference numeral 32 denotes the power supply circuit (intelligent power supply) comprising the power control CPU (PC-CPU); 33, a power switch for turning on/off the power supply of the portable computer main body; and 34L and 34R, main battery packs (M-BATA and M-BATB) which comprise rechargeable batteries, and are detachable from the apparatus main body (PC main body). In this embodiment, one of these batteries is selected as a battery to be used (battery for supplying a power supply voltage) under the control of the power supply circuit 30, and when the selected battery is discharged to its use limit, the battery to be used is switched, and the other battery is used. Reference numeral 34S denotes a sub battery (S-BAT) which also comprises a rechargeable battery, and is incorporated in the main body. The sub battery 34S supplies a backup power supply voltage (VBK) to memories to be backed up, such as the RAM 13, the extension RAM 40, the VRAM 27, and the like.

Reference numeral 40 denotes the extension RAM which can be inserted/removed in/from the special-purpose card slot of the portable computer main body. In this embodiment, an arbitrary one of four different memory cards including existing (old type) 1-and 2-MB memory cards, and new (new type) 4- and 8-MB memory cards is mounted. In this case, the old type memory card (1 MB or 2 MB) and the new (new type) memory card (4 MB or 8 MB) have different read/write access times. The old type memory card (1 MB or 2 MB) requires a wait (2 waits) time twice that of the new type memory card (4 MB or 8 MB). In order to realize a memory card interface common to both the old and new type memory cards, the wait controller 18 switches a wait value (1 wait/2 waits) in accordance with the mounted extension RAM (memory card) 40. This wait value is set in an I/O port register in the wait controller 18 in the initial setting processing under the control of the CPU 11. Every time the mounted extension RAM 40 is to be accessed, the wait controller 18 performs access control of the mounted extension RAM (memory card) 40 in the read/write cycle according to the wait value (1 wait/2 waits) set in the register.

Reference numeral 41 denotes the extension unit selectively connected to the extension bus connector (EEC) 20. Various extension optional devices such as an extension memory board, a communication board, and the like are mounted on the extension unit 41.

When the extension unit 41 is connected to the extension bus connector (EBC) 20, a refresh signal is output onto the system bus 10A, and the extension memory board, the communication board, or the like in the extension unit 41 performs operation control using the refresh signal. For example, when the extension memory board is mounted, refresh control is made using the refresh signal on the system bus 10A. When the communication board is mounted, for example, time-out processing is executed. The refresh operations of the RAM 13 and the mounted extension RAM (memory card) 40 are also controlled by the refresh signal on the system bus 10A.

On the other hand, when the extension unit 41 is not connected to the extension bus connector (EBC) 20, the refresh signal is output not onto the system bus 10A but onto the internal bus 10B. In this case, the refresh operations of the RAM 13 and the mounted extension RAM (memory card) 40 are controlled by the refresh signal on the internal bus 10B.

Reference numeral 42 denotes the internal connector for interface-connecting the hard disk pack stored in the main body when the portable computer main body is upgraded to a hard-disk (HDD) mount type (which mounts one HDD and one FDD). The hard disk pack 43 is interface-connected via the connector 42.

Fig. 2 is a circuit diagram showing principal part of the refresh mode controller 15 in the above embodiment.

The refresh mode controller 15 comprises a refresh signal switching circuit 15b and a refresh signal generator 15c in addition to the refresh control register (RFR) 15a, as shown in Fig. 2. The refresh signal switching circuit 15b selectively outputs a refresh signal RF generated by the refresh signal generator 15c in the controller 15 onto the system bus 10A or the internal bus 10B. The system bus 10A or the internal bus 10B to which the refresh signal is to be output is determined in accordance with the content of the control bit (C) in the refresh control register (RFR) 15a set by the CPU 11. More specifically, when the control bit (C) is "1", an AND gate G1 is enabled, and the refresh signal RF is output as a refresh signal RFa onto the internal bus 10B. When the control bit (C) is "0", an AND gate G2 is enabled, and the refresh signal is output as a refresh signal RFb onto the system bus 10A.

Fig. 3 is a circuit diagram showing in detail the refresh signal generator 15c shown in Fig. 2. As shown in Fig. 3, in the refresh signal generator 15c, an oscillation frequency signal from a crystal oscillator 51 is frequency-divided by a first frequency divider 53 to generate a refresh signal having a first refresh cycle. This refresh signal is applied to one input terminal of an AND gate 57. The frequency-division signal from the first frequency divider 53 is applied to a second frequency divider 55 to generate a refresh signal having a second refresh cycle. This refresh signal is applied to one input terminal of an AND gate 59. The other input terminal of each of the AND gates 57 and 59 is applied with control data indicating a high-speed or normal refresh mode. In this embodiment, since the memory 13 connected to the internal bus 10B has the same memory refresh cycle as those of the memories connected to the extension unit 41, the normal refresh mode is set. This control data will be described in detail later in the second embodiment. The output signals from the AND gates 57 and 59 are logically ORed by an OR gate 61, and the ORed signal is supplied to the refresh signal switching circuit 15b.

Fig. 4 is a flow chart showing an initial setting routine for determining a bus (system bus 10A or internal bus 10B) to which a memory refresh signal is to be output in this embodiment.

The operations according to the embodiment of the present invention will be described below with reference to Figs. 1 to 4.

When the power switch 33 is operated to turn on the power supply of the portable computer main body from a state wherein the power supply of the portable computer main body is kept OFF, and a normal system power supply voltage is supplied from the power supply circuit 32 to the respective components in the main body, the CPU 11 accesses the BIOS-ROM 12 to execute initialization processing shown in Fig. 4.

After normal initial setting processing upon power-on is executed, it is then checked if an extension device, i.e., the extension unit 41 is connected to the extension bus connector 20 (step S11 in Fig. 4). The presence/absence of connection of the extension unit 41 can be determined in such a manner that the CPU 11 executes reading processing of inherent identification data prepared in the extension unit 41, and checks if the reading processing of the identification data is normally executed.

If it is determined that the extension unit 41 is connected to the extension bus connector 20, the CPU 11 sets "0" in the control bit (C) of the refresh control register (RFR) 15a arranged in the refresh mode controller (RMC) 15 so as to output the refresh signal RFb onto the system bus 10A (to set the normal refresh mode) (step S12). When the control bit (C) is set to be "0", the refresh signal switching circuit 15b (Fig. 2) arranged in the refresh mode controller (RMC) 15 outputs the refresh signal RFb onto the system bus 10A (step S13). Thereafter, normal OS start processing is executed (step S16).

In this manner, when the extension unit 41 is connected to the extension bus connector 20, since the refresh signal RFb is output onto the system bus 10A, the extension memory board, the communication board, or the like in the extension unit 41 can perform control operations such as refresh control, time-out processing, and the like using the refresh signal RFb. Thus, the normal operation of the extension unit 41 can be guaranteed while being synchronized with the portable computer main body. The refresh operations of the RAM 13 and the extension RAM 40 can also be performed using the refresh signal RFb on the system bus 10A.

If it is determined that the extension unit 41 is not connected to the extension bus connector 20, the CPU 11 sets "1" in the control bit (C) of the refresh control register (RFR) 15a arranged in the refresh mode controller (RMC) 15 so as to output the refresh signal RFa onto the internal bus 10B (to set the high-speed refresh mode) (step S14). When the control bit (C) is set to be "1", the refresh signal switching circuit 15b (Fig. 2) arranged in the refresh mode controller (RMC) 15 outputs the refresh signal RFa onto the internal bus 10B (step S15). Thereafter, normal OS start processing is executed (step S16).

In this manner, when the extension unit 41 is not connected to the extension bus connector 20, since the refresh signal RFa is output onto the internal bus 10B, the refresh operations of the RAM 13 and the extension RAM 40 are controlled by the refresh signal RFa on the internal bus 10B. In this case, since no refresh signal is output onto the system bus 10A, the occupation period of the system bus 10A by this refresh signal can be eliminated, and use efficiency of the system bus 10A can be improved accordingly. Therefore, operation efficiency of the components connected to the system bus 10A can be improved, and hence, the operation performance of the overall system can be improved.

The second embodiment of the present invention will be described below.

In the first embodiment, when the extension unit 41 is connected to the portable computer, the CPU 11 outputs the refresh signal onto the system bus 10A so as to supply the refresh signal to the memory connected to the extension unit. When the extension unit 41 is not connected, the CPU 11 outputs the refresh signal onto the internal bus 10B to shorten the CPU wait time as much as possible, thereby increasing the processing speed of the CPU. In the first embodiment, the refresh cycle of the refresh signal output onto the system bus 10A is the same as that of the refresh signal output onto the internal bus 10B.

In recent years, along with the developments of memory ICs, a high-speed refresh operation with a long refresh interval can be realized. The high-speed memory refresh operation employs a method capable of refreshing a memory capacity several times that in a normal memory refresh mode at a time, and can reduce the number of times of memory refresh operations per unit time to half or less that in a conventional normal memory refresh mode. Thus, the stop time of the CPU can be reduced, and the processing speed of the overall system can be increased. However, when an extension card corresponding to the normal memory refresh mode is connected to the extension unit, and is used, the memory refresh operation cannot be normally executed by the high-speed refresh method alone. In the second embodiment, when the high-speed refresh mode is set in the initial setting routine in the system setup processing, and when the extension unit is not connected, the high-speed refresh mode is set in the refresh control register 15a. On the other hand, when the extension unit is connected, since whether a memory connected to the extension unit 41 is to be operated in the high-speed refresh mode or the normal refresh mode cannot be determined, the normal refresh mode is set in the refresh control register 15a. In this embodiment, the memory on the portable computer side is also connected to the system bus 10A. Therefore, the control data C in the refresh control register 15a is "0".

The operations of the second embodiment will be described below with reference to the flow chart shown in Fig. 5.

When the power switch of the system is turned on, the CPU 11 executes a setup processing program stored in the ROM 12, and displays a selection menu for the setup processing on the display device 37. The selection menu includes data for selecting the high-speed or normal refresh mode. The high-speed or normal refresh mode data selected by an operator is stored in a predetermined register in the backup RAM 19.

In step S21 in system initialize processing shown in Fig. 5, the CPU 11 refers to the refresh mode data stored in the predetermined register in the backup RAM 19. If it is determined that the normal refresh mode is selected, the CPU 11 sets the normal refresh mode in the refresh control register 15a in step S24. As a result, logic "0" is applied to one input terminal of each of the AND gates 57 and 59. Thus, a normal refresh signal from the frequency divider 55 is supplied to the refresh signal switching circuit 15b via the OR gate 61. In this embodiment, since the refresh signal switching circuit 15b is always set to be "0", the refresh signal switching circuit 15b outputs the normal refresh signal onto the system bus 10A. On the other hand, if it is determined in step S21 that the high-speed refresh mode is selected, the CPU 11 checks in step S22 if the extension unit 41 is connected. In this case, the CPU reads an I/O port (not shown) connected to the extension unit, and if the CPU can read a predetermined value, it determines that the extension unit is connected. If it is determined in step S21 that the extension unit 41 is connected, the CPU 11 sets the normal refresh mode in the refresh control register 15a in step S24, as described above. On the other hand, if it is determined in step S21 that the extension unit 41 is not connected, the CPU 11 sets the high-speed refresh mode in the refresh control register 15a. As a result, logic "1" is applied to one input terminal of each of the AND gates 57 and 59. Thus, a high-speed refresh signal from the frequency divider 53 is output onto the system bus 10A via the AND gate 57, the OR gate 61, and the refresh signal switching circuit 15b.

**Claims**

1. A portable computer characterized by comprising:

    a system bus (10A);
    an extension bus connector (20) connected to said system bus;
    an internal bus (10B);
    a memory (13) connected to said internal bus, and requiring a refresh signal;
    means for determining whether or not an extension unit (41) is connected to said extension bus connector, and outputting a determination signal, a memory being able to be connected to said extension unit;

means (15), connected to said system bus and said internal bus, for generating the refresh signal to be supplied to said memory; and

means (11, Fig. 4), responsive to the determination signal, for, when said extension unit is connected to said extension bus connector, outputting the refresh signal onto said system bus, and for, when said extension unit is not connected to said extension bus connector, outputting the refresh signal onto said internal bus.

2. A computer according to claim 1, characterized in that said memory connected to said internal bus has the same memory cycle as that of the memory connected to said extension unit.

3. A computer according to claim 1, characterized in that said means for determining whether or not said extension unit is connected reads an I/O port inherent to said extension unit to discriminate whether or not said extension unit is connected.

4. A computer according to claim 1, characterized in that said means for outputting the refresh signal comprises switching means (15b) for selecting, in accordance with the discrimination signal, whether the refresh signal is output onto said internal bus or said system bus.

5. A portable computer characterized by comprising:

an extension bus connector (20) for connecting an extension unit (41);

a first memory (13) incorporated in said portable computer, and comprising one of a memory operated in a first refresh mode, and a memory operated in a second refresh mode having a refresh cycle shorter than that of the first refresh mode;

means (11) for discriminating whether or not said extension unit is connected to said extension bus connector, a second memory which is operated in the second refresh mode being able to be connected to said extension unit;

means (11, Fig. 5) for setting a refresh mode of said first memory; and

means (11, Fig. 5) for, when the refresh mode of said first memory is set to be the first refresh mode, determining that said extension unit is connected to said extension bus connector, operating said first and second memories in the second refresh mode, and for, when said extension unit is not connected, operating the first memory in the first refresh mode.

6. A computer according to claim 5, characterized in that said first memory comprises a battery backup memory.

7. A computer according to claim 5, characterized in that a memory cycle of said first memory is longer than that of said second memory.

F I G. 1

F I G. 2

C = "1"; RFa
C = "0"; RFb

F I G. 3

EP 0 484 760 A2

INITIAL SETTING ROUTINE

IS EXTENSION UNIT CONNECTED ? — S11

NO

YES

SET IN RFR NORMAL REFRESH (RFb) MODE — S12

OUTPUT REFRESH SIGNAL ONTO SYSTEM BUS — S13

SET IN RFR HIGH SPEED REFRESH MODE (RFa) — S14

OUTPUT REFRESH SIGNAL ONTO INTERNAL BUS — S15

START OS — S16

F I G. 4

START

S21 SETTING
OF PROCESSING SPEED OF
BACKUP MEMORY

NORMAL REFRESH

HIGH-SPEED REFRESH

S22 IS
EXPANSION UNIT
CONNECTED ?

PRESENCE OF
EXTENSION UNIT

ABSENCE OF EXTENSION UNIT

S23 SET IN REFRESH CONTROL REGISTER
HIGH-SPEED REFRESH MODE

S24 SET IN REFRESH CONTROL
REGISTER NORMAL
MEMORY REFRESH

END

FIG. 5